Europäisches Patentamt

(19) European Patent Office

Office européen des brevets

(11) Numéro de publication : **0 377 352 B1**

(12) **FASCICULE DE BREVET EUROPEEN**

(45) Date de publication du fascicule du brevet :
21.08.91 Bulletin 91/34

(51) Int. Cl.⁵ : **G09F 9/33, H01L 25/075**

(21) Numéro de dépôt : **89403222.6**

(22) Date de dépôt : **22.11.89**

(54) **Bande éclairante souple à diodes électroluminescentes.**

(30) Priorité : **29.11.88 FR 8815560**

(43) Date de publication de la demande :
**11.07.90 Bulletin 90/28**

(45) Mention de la délivrance du brevet :
**21.08.91 Bulletin 91/34**

(84) Etats contractants désignés :
**DE ES GB IT**

(56) Documents cités :
**FR-A- 2 426 381**
**FR-A- 2 512 238**
**FR-A- 2 518 317**
**FR-A- 2 524 155**
**US-A- 4 271 408**
**US-A- 4 603 496**
**PATENT ABSTRACTS OF JAPAN vol.9, no. 173(E-329)(1896), 18 juillet 1985; & JP-A-60 045079**

(73) Titulaire : **VALEO VISION**
**17, rue Henri Gautier**
**F-93012 Bobigny Cédex (FR)**

(72) Inventeur : **Le Creff, René**
**13 rue Benoit Voisin**
**F-89100 Sens (FR)**
Inventeur : **Brassier, Marc**
**19 rue de Rosiers**
**F-89100 Sens (FR)**
Inventeur : **Depardieu, Dominique**
**5 Allée du Foulon**
**F-89000 Auxerre (FR)**
Inventeur : **Montalan, Dominique**
**2 rue du Tau**
**F-89100 Sens (FR)**
Inventeur : **Portefaix, Roger**
**3 rue du Champ de Ploix**
**F-89510 Veron (FR)**

(74) Mandataire : **Lemaire, Marc**
**VALEO Service Propriété Industrielle 30, rue Blanqui**
**F-93406 Saint-Ouen Cédex (FR)**

## Description

L'invention concerne une bande éclairante souple à diodes électroluminescentes composée d'une matrice d'éléments électroluminescents montés sur un élément support isolant présentant des trajets conducteurs pour leur interconnexion électrique et disposés chacun au foyer d'un élément optique de collimation constitué par une cavité, en forme de conique, réfléchissante.

Il est connu des matrices dans laquelle les éléments électroluminescents sont montés sur un substrat isolant et sont disposés chacun au foyer d'un élément optique de collimation, lesquels éléments sont constitués par des cavités paraboliques réfléchissantes ménagées à la face supérieure d'au moins une plaque dont la face inférieure recouvre la face supérieure du substrat. Les éléments électroluminescents sont des diodes sous boîtier d'un type classique et présentant des cavités paraboliques réfléchissantes. Les diodes sont maintenues mécaniquement par une plaque d'insertion formant le substrat. Une carte de circuit imprimé simple ou double face est utilisée pour réaliser les connexions électriques.

Cette matrice présente l'inconvénient d'un nombre élevé d'éléments et d'un montage relativement compliqué car nécessitant des opérations d'alignement précis du circuit imprimé et du substrat, d'orientation préalable de l'anode et de la cathode des éléments électroluminescents et d'insertion de celles-ci, chacune dans deux trous alignés du substrat et du circuit imprimé, et de mise en place de la plaque portant les cavités paraboliques.

Suivant une solution plus simple, décrite dans la demande de brevet FR-A-2426381, des éléments électroluminescents sont positionnés dans des cuvettes métallisées d'un support, en étant maintenues au-dessus de celles-ci par des fils soudés à des interconnexions métalliques déposées sur des parties planes du support situées entre les cuvettes.

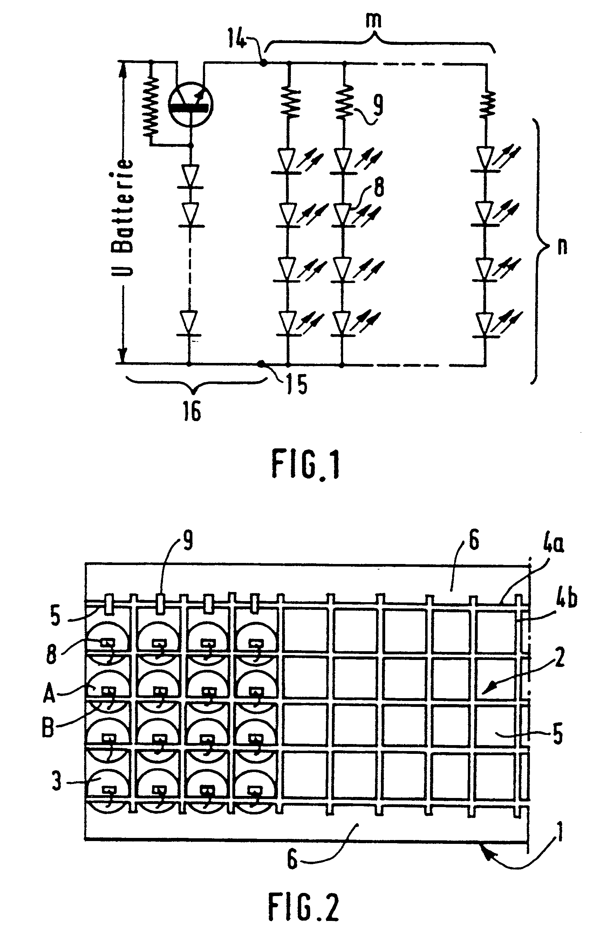

La présente invention vise à simplifier encore l'obtention d'une bande éclairante à partir d'une matrice d'éléments électroluminescents montés selon le schéma type représenté sur la figure 1.

L'invention concerne à cet effet une bande éclairante souple à diodes électroluminescentes composée entre autre d'une matrice d'éléments électroluminescents montés sur un élément support présentant des trajets conducteurs pour leur interconnexion et disposés chacun au foyer d'un élément optique de collimation constitué par une cavité en forme de conique munie d'un revêtement métallique caractérisée en ce que les cavités sont obtenues par moulage de demi-coquilles à même la face frontale de l'élément support isolant sur la surface tout ou en partie de laquelle est déposé un revêtement métallique et en ce que les trajets conducteurs sont réalisés à partir du revêtement métallique même.

Selon l'une des caractéristiques essentielles de l'invention, la face frontale du support isolant, munie d'un revêtement métallique, présente un alignement de cavités séparées par un quadrillage de moyens diélectriques dont la trame est combinée de manière à ce que les unes, dans un sens séparent parallèlement en deux parties distinctes la surface de chacune des cavités, les autres dans l'autre sens tangentent sensiblement et parallèlement les ouvertures des mêmes cavités.

Selon une autre particularité de l'invention les moyens diélectriques sont des rainures de faible embouchure mais inversement de fond élargi.

L'invention sera mieux comprise à la lecture de la description qui va suivre donnée à titre d'exemples non limitatifs en liaison avec les dessins sur lesquels:

— la figure 1 est un schéma type d'un montage de diodes électroluminescentes alimentées par une commande transistorisée ;

— la figure 2 est une vue frontale de la surface active de la matrice réalisée conformément à l'invention ;

— la figure 3 est une vue en perspective à plus grande échelle de l'agencement de la figure 2 ;

— la figure 4 est une vue de détail en coupe d'une cavité parabolique réfléchissante ;

— la figure 5 est une vue analogue du détail de la figure 4 montrant la protection finale de la face active de la bande éclairante ;

— la figure 6 représente un exemple de réalisation de fiches de connexion extérieure de la bande éclairante ;

— les figures 7 et 8 sont des vues de profil de la bande éclairante, respectivement avant et après la conformation des fiches de connexion extérieure ;

— la figure 9 est une vue qui représente deux réseaux distincts de bande éclairante et leur connexion séparée à partir d'une seule longueur de bande ;

— les figures 10 et 11 sont les vues respectives frontale et de profil d'un exemple de réalisation d'un feu escamotable de sécurité comportant une bande éclairante conforme à l'invention ;

— la figure 12 est une vue en coupe d'un exemple de réalisation d'un feu d'éclairage ou de signalisation comportant une bande éclairante selon un autre mode de réalisation de l'invention.

Conformément à l'invention, la matrice 1 est constituée d'un élément support 1a qui présente sur sa face frontale 2 un alignement de cavités 3 en forme de conique, sinon de quadriques ainsi qu'un quadrillage de rainures 4 à parois rentrantes dont la trame est combinée de manière à ce que les unes 4a dans un sens séparent parallèlement en deux parties distinctes A et B la surface de chacune des cavités 3, les autres 4b dans l'autre sens tangentent sensiblement et parallèlement les ouvertures des mêmes cavités 3.

L'élément support 1a est moulé dans une matière plastique souple injectée tels les matériaux polyesters-élastomères ou polyamides-élastomères. La fluidité de la matière doit être suffisamment élevée pour permettre une reproduction fidèle et un bon remplissage des micro-reliefs de la face frontale 2. De préférence le module d'élasticité de la matière doit être au moins compris entre 10 et 600 MPa et l'allongement à la rupture supérieure à 150% pour aboutir à un démoulage élastique particulièrement dans les zones desdites rainures 4 dont les parois rentrantes sont conformées de façon à obtenir des lèvres relativement rigides réduisant sensiblement l'embouchure apparente de chacune des rainures 4 à fond inversement élargi, sinon éloigné et du moins masqué.

La face frontale 2 de l'élément support 1a, y compris les cavités 3, est revêtue sur toute ou partie de sa surface d'un revêtement métallique 7 pour constituer, d'une part autant de micro-miroirs réfléchissants optiques qu'il y a de cavités 3, et d'autre part, un réseau de carrés 5 et de lamelles 6 électriquement conducteurs.

Bien que l'ensemble de la face frontale 2 de l'élément support 1a soit soumis à l'opération de métallisation sous vide, les rainures 4 empêchent le revêtement métallique de pénétrer et couvrir toutes les parois intérieures desdites rainures 4, qui conséquemment ne peut réaliser une couche unique continue, mais forme des portions 5 et 6 électriquement conductrices et bien isolées les unes des autres pour aboutir au maillage de liaison souhaité représenté sur la figure 2.

Les diodes électroluminescentes 8 sont positionnées et orientées uniformément chacun dans chacun des micro-miroirs des cavités 3 et connectées par collage et par soudage de manière que l'anode et la cathode reliées l'une et l'autre respectivement aux parties distinctes conductrices A et B des cavités réfléchissantes 3, contribuent en fonction de la trame du quadrillage de carrés 5 et lamelles 6 de jonction électrique à constituer un montage électronique de m dérivations parallèles successives longitudinales de n diodes couplées en série dans le sens latéral de bande, des composants 9 de technologie CMS pouvant être également intégrés sur la face active 2 de bande pour relier chacune des dérivations de diodes à l'une et/ou l'autre des lamelles 6 de distribution électrique commune à chaque branche (figure 1).

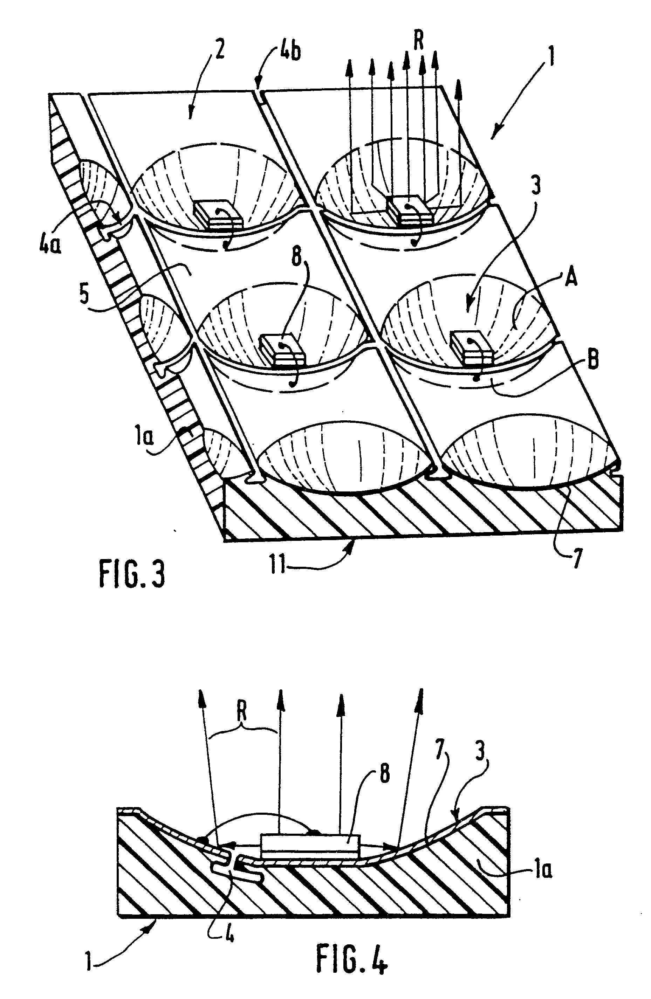

L'ensemble ainsi équipé comme représenté sur les figures 3-4 et 5 est revêtu sur au moins la face active 2 d'éclairage d'une matière organique transparente 10 présentant toutes les caractéristiques optiques utiles (comme par exemple, vernis/polyuréthane, polysiloxane, mélamine, acrylique, etc...) et au verso sur la face 11 d'accostage à un support éventuel, d'une couche auto-adhérente pelliculable 12 de très faible épaisseur et d'un élément de protection extérieure détachable 13.

Des moyens de raccordement électrique 14 et 15 extérieur à au moins un module de commande transistorisé 16 de génération/régulation de courant sont prévus sur toute la longueur des lamelles conductrices métallisées 6 délimitant les bords longitudinaux de la matrice 1 réalisée.

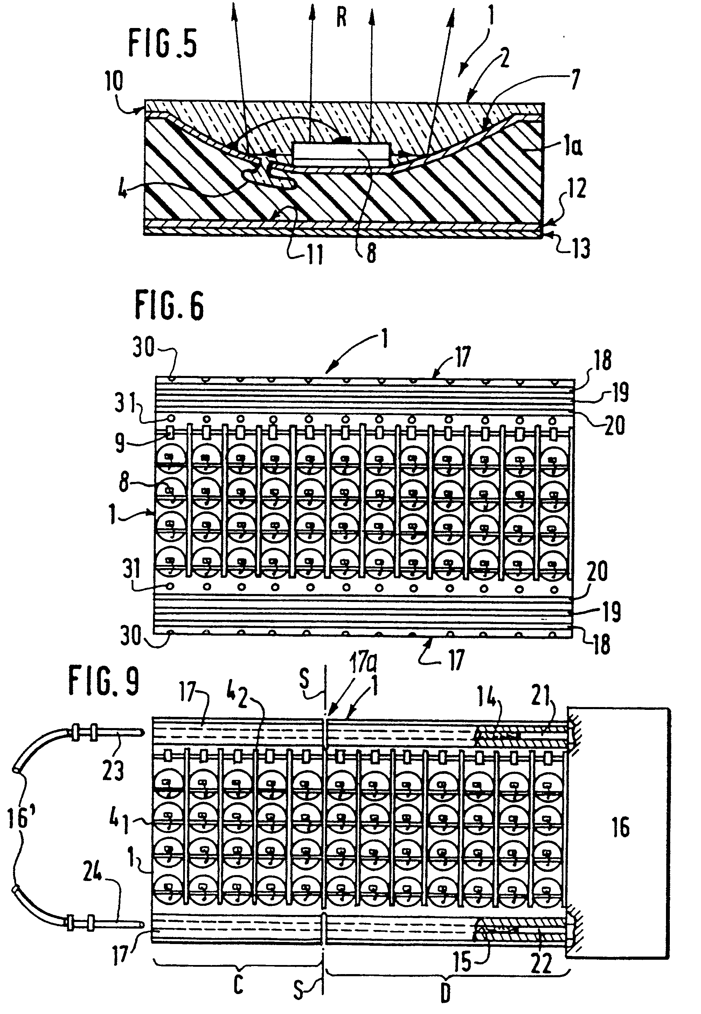

Comme représentés sur les figures 6 à 8, les moyens de raccordement électrique 14 et 15 sont constitués chacun longitudinalement de part et d'autre de la matrice 1, par le rabat et la solidarisation par clipsage et/ou collage, d'une bordure 17 à gorge médiane 18 reliée de moulage à la partie active centrale de bande par une réduction d'épaisseur constituant un moyen d'articulation souple 19. La bordure 17 est disposée, après l'opération de métallisation en recouvrement et concordance d'une gorge longitudinale 20 correspondante de ladite face active 2 de la bande et qui aboutit à constituer, par l'association coaxiale des gorges métallisées 18 et 20, l'une des fiches de connexion électrique extérieure 14,15 de la bande éclairante.

La conformation des fiches de connexion 14,15 est rendue permanente par le fait que chacune des bordures 17 et des zones correspondantes de réception de la face active 2 de l'élément support 1 sont respectivement pourvues d'une succession de pions 30, et réciproquement d'orifices 31 en concordance, destinés à permettre en combinaison le verrouillage en position des bordures 17 rabattues sur la face 2.

Cette fixation peut éventuellement être renforcée par l'adjonction d'un liant préalablement introduit dans lesdits orifices de maintien 31.

Tout autre dispositif de connexion extérieure pourra être prévu tel que clips-ressorts, barrettes e préhension, et autres systèmes de connectique connus qui assureraient un contact électrique par pincement d'une lamelle conductrice de bord 6.

Afin de procurer une certaine souplesse à la bande éclairante, il est avantageux de prévoir sur la face d'accostage 11 opposée à la face active 2, une pluralité de rainures 25 de réduction/amincissement de l'épaisseur de la matrice 1 afin de créer des zones préférentielles de pliage et courbure de la bande.

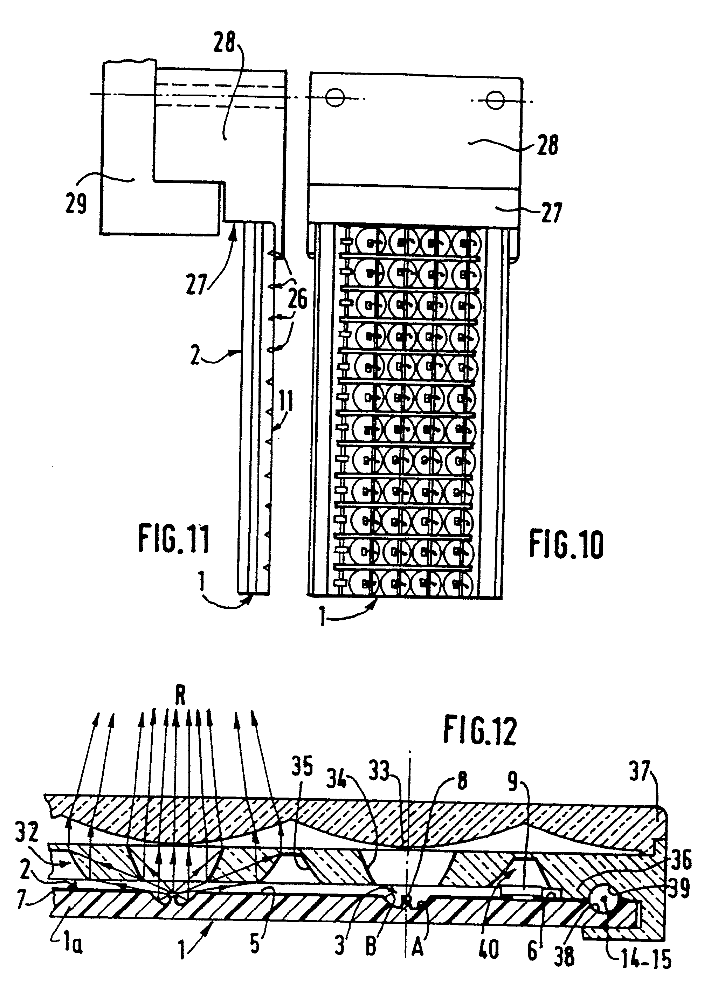

Dans une même longueur de bande, comme représenté sur la figure 9, il est possible de rendre les fiches de connexion électrique 14,15 extérieure, sectionnables à la demande, pour réaliser au moins deux fonctions C et D d'éclairage/signalisation distinctes, lesquelles parties fonctionnelles peuvent ainsi être connectées séparément aux bornes individualisées de raccordement 21-22 et 23-24, de modules de commande transistorisés 16 et 16' distincts.

Pour cela, l'une au moins des bordures longitudinales 17 d'alimentation positive de la bande comporte une fente 17a entaillée suivant la ligne S jusqu'à l'une des rainures diélectriques 4b afin de raccorder à chacune des extrémités de bande les moyens de liaison spécifique 21-22 et 23-24 de chacun des modules 16 et 16′ nécessaires aux fonctionnements séparés et/ou simultanés de deux fonctions désirées C et D.

L'adjonction sélective d'un filtre transparent de couleur complémentaire peut être rapporté sur le dessus de la face active 2 de la matrice 1 pour assurer une couleur et/ou une répartition optique différente pour chacune des fonctions couplés C et D.

Les figures 10 et 11 montrent plus particulièrement l'application d'une bande éclairante conforme à l'invention à un feu escamotable de sécurité. La matrice 1 est pourvue de rainures d'indexation 26 sur sa face arrière 11 et est enfichée dans l'ouverture d'un connecteur 27 d'un module de commande transistorisé 28 dont le boîtier forme en même temps le socle de fixation à un élément support 29, telle barre arrière de véhicule poids lourd.

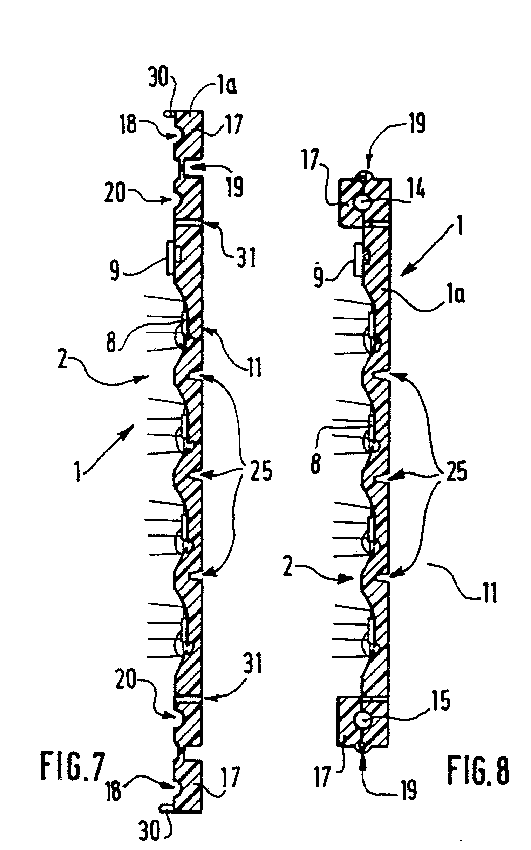

Les rainures 26 peuvent former avantageusement les zones préférentielles de pliage au même titre que les rainures 25 des figures 7 et 8.

On a représenté sur la figure 12 un autre mode de réalisation de la bande éclairante qui se distingue essentiellement en ce que l'on dispose sur la face active 2, à une certaine distance de celle-ci, un écran de récupération additionnel 32, capable de réfléchir et orienter, sensiblement parallèlement à l'axe optique du faisceau lumineux généré par chaque diode 8, tous les rayons incidents émis par chacune desdites diodes 8, et également en augmentant l'angle solide de réflexion d'adapter la surface apparente d'éclairage de chacune des cavités 3 à la surface apparente du relief optique élémentaire 33 devant constituer l'écran frontal d'éclairage 37 du feu destinée à assurer la répartition et l'homogénéité d'éclairage/signalisation extérieurs désirés.

L'écran de récupération additionnel 32 rapporté à l'avant de la matrice 1, est moulé dans une matière plastique transparente (voir translucide selon la fonction finale à aboutir), de façon à constituer une paroi de transmission de lumière présentant localement, et en regard de chaque cavité 3, au moins deux surfaces élémentaires de coniques tronqués, décalées, coaxiales et concommitantes 34, 35 dont les axes sont alignés et confondus avec celui de la cavité 3 correspondante. Les surfaces élémentaires 34, 35 sont conçues de manière que seules les parties en creux recto, verso dudit écran 32 sont métallisées.

La distance de l'écran à la face active 2 de l'élément support 1a est déterminée par la hauteur donnée d'un épaulement d'appui 36.

La première surface centrale de réflexion 34, qui constitue un orifice de forme conique, traversant toute l'épaisseur de l'écran 30, est sensiblement de même paramètre et même foyer que la surface conique de la cavité 3 en regard, qu'elle prolonge par ses dimensions et sa position décalée vers l'avant pour travailler optiquement en réflexion directionnelle complémentaire.

La seconde surface conique de réflexion périphérique 35, enveloppe coaxialement à distance la première 34 sans traverser toute l'épaisseur de l'écran 32 et est d'un paramètre plus grand, présentant sensiblement le même foyer que la cavité réfléchissante 3 et se trouve en une position décalée qui lui permet de capter tous les rayons incidents émis par la diode 8 qui passent au travers de l'intervalle créé en relation entre ledit écran 32 et l'élément support 1a pour diriger ensuite ces rayons dans une direction sensiblement parallèle à son axe focal selon une grandeur d'ouverture apparente de réflexion/réfraction de l'écran 32 correspondant sensiblement à la grandeur de la surface apparente d'éclairement d'un relief 33 d'un écran transparent frontal 37 de répartition et homogénéisation de l'aspect et de l'éclairage extérieur du feu constitué.

Les moyens de raccordement électrique 14,15 constitués longitudinalement de part et d'autre de la matrice 1 sont obtenus par le positionnement, en vis-à-vis, d'une gorge 38 ménagée le long d'un des bords longitudinaux de l'élément support 1a et métallisée simultanément avec ledit élément support dans lequel elle est ménagée avec une autre gorge 39 de dimension et de forme correspondante, également métallisée et ménagée dans l'écran 32, au niveau de l'épaulement 36.

Les composants 9 de technologie CMS destinés à connecter chacune des dérivations de diodes 8 à l'une et/ou l'autre des lamelles 6 de distribution électrique sont aisément intégrés sur la face active 2 de l'élément support 1a en des positions correspondantes à ceux d'évidements longitudinaux 40.

L'invention ne se limite pas aux modes de réalisation décrits et représentés. Ainsi on peut former un réseau de carrés 5 et lamelles 6 électriquement conducteurs constitués à partir du revêtement métallique 7 déposé selon l'un des procédés de dépôt connus et de préférence sous vide, par micro-découpe de la couche métallique conductrice 7 sous l'impact du faisceau focalisé d'un laser de micro-intervention sur couches minces.

Cette technique qui peut remplacer celle faisant intervenir les rainures, étant connue en elle-même, n'a pas été représentée sur les dessins.

## Revendications

1. Bande éclairante a diodes électroluminescentes composée entre autre d'une matrice (1) d'éléments électroluminescents montés sur un élément support isolant souple (1a) présentant des trajets conducteurs pour leur interconnexion et disposés chacun au foyer d'un élément optique de collimation constitué par une cavité (3) en forme de conique munie d'un revêtement métallique (7), caractérisée par le fait que les cavités (3) sont obtenues par moulage de demi-coquilles a même la face frontale (2) dudit élément support isolant souple (1a) sur tout ou partie de la surface de laquelle est déposé un revêtement métallique (7) constituant autant de micro-miroirs réfléchissants optiques qu'il y a de cavités (3) et constituant des trajets conducteurs (5, 6) pour l'interconnexion des éléments électroluminescents (8).

2. Bande éclairante selon la revendication 1, caractérisée en ce que la face frontale (2) de l'élément support souple (1a) munie du revêtement métallique conducteur (7) présente un alignement de cavités réfléchissantes (3) séparées par un quadrillage de moyens diélectriques dont la trame est combinée de manière a ce que les unes (4a) un sens séparent parallèlement en deux parties distinctes (A et B) la surface de chacune des cavités (3), les autres (4b) dans l'autre sens tangentent sensiblement et parallèlement les ouvertures des mêmes cavités (3).

3. Bande éclairante selon la revendication 2, caractérisée en ce que les moyens diélectriques sont des rainures (4a, 4b) de faible embouchure, mais inversement de fond élargi.

4. Bande éclairante selon la revendication 2, caractérisée en ce que les moyens diélectriques sont constitués de micro-découpes du revêtement métallique (7).

5. Bande éclairante selon la revendication 2, caractérisée en ce que les diodes électroluminescentes (8) sont positionnées et orientées uniformément chacune dans chacune des cavités (3) et connectées par collage et/ou soudage de manière que l'anode et la cathode reliées respectivement aux parties conductrices distinctes (A et B) des cavités (3) assurent la jonction électrique continue de m dérivations parallèles successives longitudinales de n diodes (8) couplées en série dans le sens latéral de la bande éclairante, lesquelles m dérivations de diodes (8) sont reliées à l'une et/ou l'autre des lamelles (6) de distribution électrique commune, s'étendant tout le long des bords longitudinaux de l'élément support isolant souple (1a), réalisant ainsi la matrice (1).

6. Bande éclairante selon la revendication 5, caractérisée en ce que la face frontale (2) de la matrice (1) est revêtue d'une couche de protection chimique et mécanique transparente (10).

7. Bande éclairante selon la revendication 5, caractérisée en ce que des moyens de raccordement électrique (14, 15) sont prévus sur toute ou en partie de la longueur des lamelles conductrices (6) délimitant les bords longitudinaux de la matrice (1) et sont constitués par le rabat d'une bordure (17) à gorge médiane (18) reliée de moulage par une charnière-film (19) à la matrice (1) et venant par association coaxiale en recouvrement et concordance avec une gorge longitudinale (20) réalisée sur la face (2) de la matrice (1) pour aboutir à des fiches de connexion conductrices (14, 15).

8. Bande éclairante selon la revendication 7, caractérisé en ce que chacune des bordures (17) est pourvue d'une succession de pions (30) en concordance réciproquement avec des orifices (31) ménagés dans la zone correspondante de réception de la face (2).

9. Bande éclairante selon la revendication 5, caractérisée en ce que des fiches de connexion (14, 15) sectionnables à la demande pour réaliser au moins deux réseaux C et D distincts à partir d'une même longueur de matrice (1) sont connectés séparément aux bornes individualisées de raccordement (21-22 et 23-24) de modules (16 et 16') distincts.

10. Bande éclairante selon la revendication 9, caractérisée en ce que les fiches de connexion sont sectionnables par le fait que des fentes (17a) sont entaillées dans au moins l'une des bordures longitudinales (17) selon une ligne transversale (S) jusqu'à l'un des moyens diélectriques (4, 4A) de la matrice (1).

11. Bande éclairante selon la revendication 7, caractérisée en ce que des rainures parallèles 25 sont ménagées de moulage avec l'élément support (1a) sur la face d'accostage (11) de la matrice (1), dans l'un au moins des sens de la trame des carrés (5) et lamelles (6) conducteurs diminuant localement l'épaisseur de bande.

12. Bande éclairante selon l'une quelconque des revendications précédentes, caractérisée en ce qu'un écran de récupération additionnel (32) transparent est rapporté à l'avant de la matrice (1), de façon à constituer une paroi de transmission de lumière présentant localement et en regard de chaque cavité (3) au moins deux surfaces élémentaires (34, 35), de coniques tronqués, décalées, coaxiales et concomitantes dont les axes sont confondus et alignés avec celui de la cavité (3) correspondante.

13. Bande éclairante selon la revendication 12, caractérisée en ce que l'une, centrale, des surfaces de réflexion (34) se présente sous la forme d'un orifice de forme conique traversant toute l'épaisseur de l'écran (32) et est sensiblement de même paramètre et même foyer que la surface conique de la cavité (3), en regard, qu'elle prolonge par ses dimensions et sa position décalée vers l'avant de la matrice (1), et en ce que l'autre surface de réflexion (35) enveloppe coaxialement à distance la surface (34) sans traverser toute l'épaisseur de l'écran de récupération (32) et est d'un paramètre plus grand, présentant sensiblement le même foyer que la cavité (3) tout en étant décalée de celle-ci.

14. Bande éclairante selon la revendication 12 ou 13, caractérisée en ce qu'un écran transparent frontal est disposé sur l'écran de récupération (32) et dont le relief (33) a une surface apparente d'éclairement correspond sensiblement à la grandeur d'ouverture apparente de réflexion/réfraction des surfaces (34, 35) dudit écran de récupération.

## Patentansprüche

1. Leuchtband mit Leuchtdioden, unter anderem bestehend aus einer Matrize (1) mit Leuchtdioden, die an einem biegsamen, isolierenden Tragelement (1a) angebracht sind, welches Leitpfade für deren gegenseitige Verbindung aufweist, jeweils angeordnet im Brennpunkt eines öptischen Kollimationselements, bestehend aus einem Hohlraum (3) von konischer Form, versehen mit einem Metallüberzug (7), **dadurch gekennzeichnet**, daß die Hohlräume (3) durch Matrizenpressung bündig mit der Vorderseite (2) des genannten biegsamen, isolierenden Tragelements (1a) hergestellt werden, auf deren ganzer oder teilweiser Oberfläche ein Metallüberzug (7) angebracht ist, der ebensoviele optisch reflektierende Mikrospiegel bildet wie Hohlräume (3) vorhanden sind und wodurch Leitpfade (5, 6) für die gegenseitige Verbindung der Leuchtelemente (8) entstehen.

2. Leuchtband nach Anspruch 1, **dadurch gekennzeichnet**, daß die Vorderseite (2) des biegsamen Tragelements (1a), die mit dem leitfähigen Metallüberzug (7) versehen ist, eine Fluchtlinie von reflektierenden Hohlräumen (3) aufweist, die durch ein Raster aus dielektrischen Mitteln getrennt sind, die so kombiniert sind, daß die einen (4a) die Oberfläche jedes der Hohlräume (3) in einer Richtung parallel in zwei verschiedene Teile (A und B) unterteilen, während die anderen (4b) in der anderen Richtung im wesentlichen und parallel die Öffnungen derselben Hohlräume (3) tangieren.

3. Leuchtband nach Anspruch 2, **dadurch gekennzeichnet**, daß es sich bei den dielektrischen Mitteln um Nuten (4a, 4b) mit kleiner Mündung, umgekehrt jedoch mit erweitertem Boden handelt.

4. Leuchtband nach Anspruch 2, **dadurch gekennzeichnet**, daß die dielektrischen Mittel aus Mikroschnitten des Metallüberzugs (7) bestehen.

5. Leuchtband nach Anspruch 2, **dadurch gekennzeichnet**, daß die Leuchtdioden (8) gleichmäßig jeweils in einem der Hohlräume (3) positioniert und ausgerichtet und durch Verklebung und/oder Verschweißung so verbunden sind, daß die jeweils mit den verschiedenen leitfähigen Teilen (A und B) der Hohlräume (3) verbundene Anode und Kathode die durchgehende elektrische Verbindung von m aufeinanderfolgenden parallelen Längsabgleitungen von n Dioden (8) sicherstellen, die in seitlicher Richtung des Leuchtbandes in Reihe geschaltet sind, wobei die Ableitungen m von Dioden (8) mit der einen und/oder der anderen der Lamellen (6) der gemeinsamen elektrischen Verteilung verbunden sind, die sich entlang den Längskanten des biegsamen isolierenden Tragelements (1a) erstrecken, so daß die Matrize (1) zustandekommt.

6. Leuchtband nach Anspruch 5, **dadurch gekennzeichnet**, daß die Vorderseite (2) der Matrize (1) mit einer transparenten chemischen und mechanischen Schutzschicht (10) überzogen ist.

7. Leuchtband nach Anspruch 5, **dadurch gekennzeichnet**, daß über die gesamte oder einen Teil der Länge der die Längskanten der Matrize (1) begrenzenden leitfähigen Lamellen (6) elektrische Verbindungsmittel (14, 15) vorgesehen sind, die aus dem Umschlag einer Einfassung (17) mit Mittelrille (18) bestehen, die über eine Filmscharnierpressung (19) mit der Matrize (1) verbunden ist und durch koaxiale Überlappung und Anpassung mit einer Längsrille (20) in Verbindung steht, die auf der Fläche (2) der Matrize (1) vorgesehen ist, um an leitfähigen Steckern (14, 15) zu enden.

8. Leuchtband nach Anspruch 7, **dadurch gekennzeichnet**, daß jede der Einfassungen (17) mit einer Reihe von Stiften (30) versehen ist, die sich gegenseitig mit Öffnungen (31) decken, die im entsprechenden Aufnahmebereich der Fläche (2) angebracht sind.

9. Leuchtband nach Anspruch 5, **dadurch gekennzeichnet**, daß Verbindungsstecker (14, 15), die auf Wunsch so getrennt werden können, daß wenigstens zwei verschiedene Netze C und D aus einer und derselben Matrizenlänge (1) entstehen, separat mit den einzelnen Anschlußklemmen (21-22 und 23-24) von verschiedenen Modulen (16 und 16′) verbunden werden können.

10. Leuchtband nach Anspruch 9, **dadurch gekennzeichnet**, daß die Verbindungsstecker dadurch trennbar sind, daß in wenigstens einer der Längseinfassungen (17) entlang einer Querlinie (S) bis zu einem der dielektrischen Mittel (4, 4A) der Matrize (1) Schlitze (17a) eingekerbt sind.

11. Leuchtband nach Anspruch 7, **dadurch gekennzeichnet**, daß parallel verlaufende Nuten (25) mit dem Tragelement (1a) auf der Kopplungsseite (11) der Matrize (1) angebracht sind, zumindest in einer Richtung der leitfähigen Quadrate (5) und Lamellen (6), wodurch örtlich die Banddicke verringert wird.

12. Leuchtband nach einem der vorherigen Ansprüche, **dadurch gekennzeichnet**, daß eine transparente, zusätzliche Rekuperationsscheibe (32) an der Vorderseite der Matrize (1) in der Weise angebaut ist, daß eine lichtdurchlässige Wandung entsteht, die örtlich und gegenüber jedem Hohlraum (3) wenigstens zwei Elementarflächen (34, 35) aus abgestupften Kegelschnitten aufweisen, die versetzt, koaxial und mitwirkend angeordnet sind und deren Achsen mit derjenigen des entsprechenden Hohlraums (3) vertauscht und ausgefluchtet sind.

13. Leuchtband nach Anspruch 12, **dadurch gekennzeichnet**, daß die mittlere Reflexionsfläche (34) die Form einer konischen Öffnung hat, die die gesamte Dicke der Scheibe (32) durchquert, und im wesentlichen den gleichen Parameter und den gleichen Brennpunkt aufweist wie die konische Oberfläche des gegenüberliegenden Hohlraums (3), der durch diese bemessungen und die versetzte Position zur Vorderseite der Matrize (1) hin verlängert wird, und daß die andere Reflexionsfläche (35) koaxial in einem bestand die Fläche (34) umgibt, ohne die gesamte Dicke der Rekuperationsscheibe (32) zu durchqueren, und einen größeren Parameter aufweist, der im wesentlichen den gleichen Brennpunkt hat wie der Hohlraum (3), jedoch im Verhältnis dazu versetzt ist.

14. Leuchtband nach Anspruch 12 oder 13, **dadurch gekennzeichnet,** daß an der Rekuperationsscheibe (32) eine vordere transparente Scheibe angeordnet ist, deren Relief (33) eine sichtbare Leuchtfläche besitzt, die im wesentlichen der sichtbaren Reflexions-/Refraktions-Öffnungsweite der Oberflächen (34, 35) der genannten Rekuperationsscheibe entspricht.

## Claims

1. A flexible lighting tape with electroluminescent diodes which includes, inter alia, a matrix (1) of electroluminescent elements mounted on a flexible, insulating support element (1a) having conductive paths for their interconnection, with each electroluminescent element being disposed at the focus of an optical collimating element which comprises a cavity (3) in the form of a conic section and having a metallic coating (7), characterised by the fact that the cavities (3) are obtained by moulding in a half shell form to extend from the frontal surface (2) of the said flexible insulating support element (1a), over all or part of the surface of which a metallic coating (7) is deposited, with the said coating constituting as many optical reflective micro-mirrors as there are cavities (3), and also constituting conductive paths (5, 6) for the interconnection of the electroluminescent elements (8).

2. A lighting tape according to Claim 1, characterised in that the frontal surface (2) of the flexible support element (1a), having the conductive metallic coating (7), has rows of reflective cavities (3) separated by a grid of dielectric means, so disposed in combination that those (4a) of the latter extending in a first direction, parallel to each other, divide the surface of each said cavity (3) into two distinct portions (A and B), while the others (4b), which extend in the other direction parallel to each other, are substantially tangential to the mouths of the said cavities (3).

3. A lighting tape according to Claim 2, characterised in that the dielectric means are in the form of grooves (4a), (4b) with narrow openings but being enlarged internally.

4. A lighting tape according to Claim 2, characterised in that the dielectric means comprise micro-cuts in the metallic coating (7).

5. A lighting tape according to Claim 2, characterised in that the electroluminescent diodes (8) are positioned and orientated uniformly, each in a respective said cavity (3), and are connected by adhesion and/or by soldering in such a way that the anode and the cathode, which are connected respectively to the separate conductive portions (A and B) of the said cavities (3), provide continuous electrical connection of m successive longitudinal parallel derivations of n diodes (8), coupled in series in the lateral direction of the lighting tape, with the said m derivations of diodes (8) being connected to one and/or the other of a plurality of common electrical distribution strips (6), extending along the whole length of the longitudinal edges of the flexible insulating support element (1a), thereby forming the said matrix (1).

6. A lighting tape according to Claim 5, characterised in that the frontal surface (2) of the matrix (1) is overlaid with a transparent layer (10) for chemical and mechanical protection.

7. A lighting tape according to Claim 5, characterised in that electrical connection means (14, 15) are provided over all or part of the length of the conductive strips (6) delimiting the longitudinal edges of the matrix (1), and comprise the flap portion of an edge portion (17) having a central groove (18) and joined, by moulding, to the matrix (1) by means of a film hinge (19), so as to be brought into register, in coaxial association and in overlying relationship, with a longitudinal groove (20) which is formed on the surface (2) of the matrix (1), so as to engage with conductive connector elements (14, 15).

8. A lighting tape according to Claim 7, characterised in that each of the said edge portions (17) is provided with a succession of pins (30), corresponding with reciprocal orifices (31) which are formed in the corresponding reception zone of the surface (2).

9. A lighting tape according to Claim 5, characterised in that the connector elements (14, 15), which can be cut as required in order to produce at least two distinct lengths C and D of tape from a given length of the matrix (1), are connected separately to the individual connection terminals (21-22 and 23-24) of separate modules (16 and 16').

10. A lighting tape according to Claim 9, characterised in that the connector elements are severable by reason of slots (17a) which are formed through at least one of the longitudinal edge portions (17) along a transverse line (S) up to one of the dialectric means (4, 4A) of the matrix (1).

11. A lighting tape according to Claim 7, characterised in that parallel grooves (25) are formed by moulding with the support element (1a) on the mounting face of the matrix (1), in at least one of the directions of the grid of conductive squares (5) and strips (6), whereby to reduce the thickness of the tape locally.

12. A lighting tape according to any one of the preceding Claims, characterised in that an additional transparent recuperation screen (32) is carried on the front of the matrix (1), so as to constitute a light transmitting wall having, locally and facing each cavity (3), at least two offset, coaxial, convergent elementary surfaces (34, 35), each in the form of a section of a truncated cone, the axes of the said surfaces being coincident with each other and aligned with that of the corresponding cavity (3).

13. A lighting tape according to Claim 12, characterised in that a central one of the reflective surfaces (34) is an orifice in the form of a conic section extending through the whole thickness of the screen (32), and is of substantially the same parameters and the same focus as the surface, in the form of a conic section, of the cavity (3) aligned with it, so as to extend the cavity to the front of the matrix (1) by virtue of its dimensions and its offset position, and in that the other reflective surface (35) coaxially envelops the surface (34), from which it is spaced, without extending over the whole thickness of the recuperation screen (32), the said other surface having a larger parameter but having substantially the same focus as the cavity (3), while being offset from the latter.

14. A lighting tape according to Claim 12 or Claim 13, characterised in that a transparent frontal screen is disposed on the recuperation screen (32), and has a profile (33), with a visible lighting surface which corresponds substantially to the size of the visible reflection/refraction aperture of the surfaces (34, 35) of the said recuperation screen.

FIG.1

FIG.2

FIG.3

FIG.4

FIG.5

FIG.6

FIG.9

FIG.7

FIG.8

**FIG.11**

**FIG.10**

**FIG.12**